# EUROPEAN PATENT SPECIFICATION

(11) **EP 1 890 366 B1**
(45) Date of publication and mention of the grant of the patent: **18.03.2015**
(21) Application number: 07113763.2
(22) Date of filing: 03.08.2007
(51) Int. Cl.: H01S 5/50

(54) **Semiconductor optical amplifier with enlarged bandwith**
Halbleiter Verstärker mit erweiterter Bandbreite
Amplificateur optique à semi-conducteur avec largeur de bande agrandie

(30) Priority: 18.08.2006 FR 0607393
(43) Date of publication of application: 20.02.2008
(73) Proprietor: ALCATEL LUCENT, 92100 Boulogne-Billancourt (FR)
(72) Inventor: Brenot, Romain, 75001, PARIS (FR); Duan, Guang-Hua, 92290, CHATENAY-MALABRY (FR)
(74) Representative: Therias, Philippe

(56) References cited:
- EP-A2- 0 450 603
- JP-A- 2000 114 670
- US-B1- 6 671 086
- US-B1- 7 079 309
- Japanese Journal of Applied Physics, Part 1 (Regular Papers, Short Notes & Review Papers) Japan Soc. Appl. Phys Japan, vol. 45, no. 8A, 4 August 2006 (2006-08-04), pages 6116-6120, XP002431044 ISSN: 0021-4922

## Description

The field of the invention is that of optical amplifiers for fibre-optic devices used especially in optical telecommunications.

Optical amplification, which has been around for some twenty years, has many advantages over conventional systems composed of optoelectronic repeaters-regenerators, in particular in WDM (wavelength division multiplexing) systems. In these WDM systems, the optical amplifiers are used for simultaneously amplifying several signals at different wavelengths.

Optical amplification is based on the phenomenon of stimulated emission. The signal is amplified in a waveguide thanks to an external injection of energy, called pumping, which creates a population inversion within the amplifying medium. The incident photons on passing through the amplifying medium give rise to photons of the same frequency, the same phase and the same direction.

At the present time, there are two broad types of optical amplifiers. These are, on the one hand, erbium-doped fibre amplifiers better known as EDFAs and, on the other hand, semiconductor amplifiers better known as SOAs. In the case of EDFAs, the pumping is optical pumping provided by a pump laser, while in the case of SOAs, the pumping is of electronic origin, an electrical pump current creating the population inversion in an active zone.

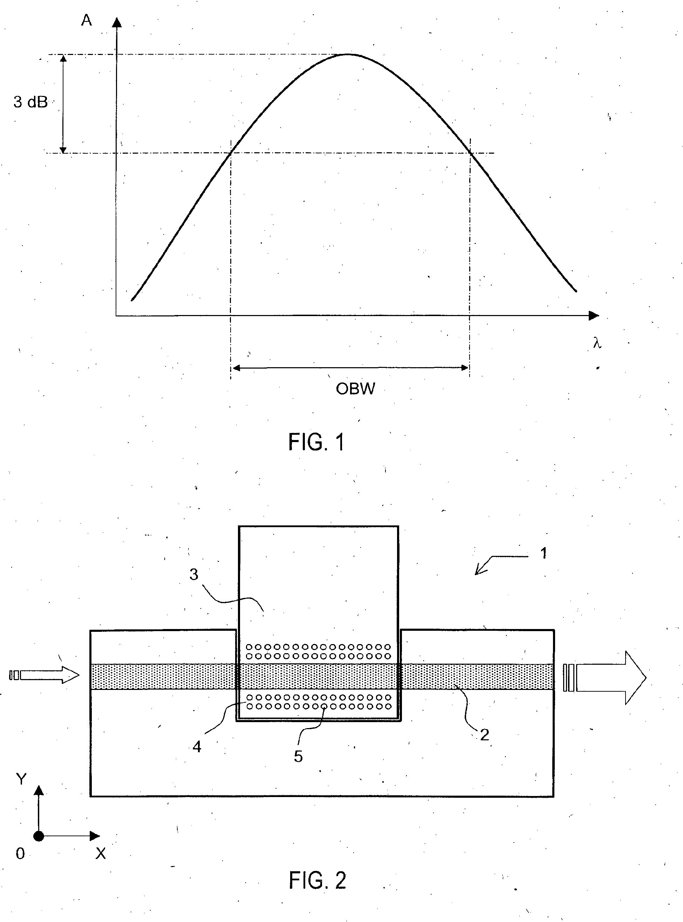

One of the important parameters of an amplifier is the spectral width of its gain curve. This width is better known as OBW (optical bandwidth). It is conventionally defined as the spectral width corresponding to the wavelength range in which the gain is greater than half the maximum gain, as indicated in Figure 1 which shows the variation A in gain as a function of the optical wavelength λ. When optical amplifiers are used in WDM devices, the optical bandwidth OBW is a fundamental parameter. This is because, since the various transmission channels are separated by a certain spectral width imposed by the optical transmission standards, the OBW will determine the maximum number of channels that can be amplified. The distance separating two channels may be up to 20 nanometres in a "coarse" WDM base configuration. Thus, to amplify eight channels corresponding to the S-C-L optical telecommunication bands, a 140 nanometre OBW is necessary.

Now, the bandwidth of an EDFA amplifier does not exceed 40 nanometres and the bandwidth of an amplifier of standard SOA type does not exceed 80 nanometres. Consequently, in the best case, two SOA amplifiers are needed to amplify all of the eight channels used, each of the two amplifiers being dedicated to one part of the bandwidth. This solution is necessarily complex to implement and incurs a substantial additional cost.

The object of the invention is to increase the bandwidth of an SOA amplifier so that a larger number of channels can be amplified simultaneously. The basis of the invention is the addition to the amplifier of an element that induces moderate losses in the maximum gain zone so as to enlarge the bandwidth of the gain curve.

In Japanese Journal of Applied Physics , vol 45 No. 8A pp 6116-6120 E. Mizuta et al describe an optical semiconductor amplifier comprising a low bandwidth photonic crystal waveguide. US7079309 B1 discloses an erbium doped optical amplifier comprising a photonic crystal waveguide for modifying the bandwidth.

More precisely, the subject of the invention is a semiconductor optical amplifier possessing an active zone, said active zone having an initial gain curve dependent on the wavelength and possessing a first bandwidth, characterized in that said amplifier includes, in the vicinity of said active zone, an electrically tuneable photonic-crystal waveguide, said waveguide being dimensioned and tuned so that the final gain curve of the optical amplifier has a second bandwidth greater than the first bandwidth.

Advantageously, since the active zone has substantially the form of a thin elongate straight stripe, the photonic-crystal waveguide consists of two identical structures placed symmetrically on either side of said stripe.

Advantageously, each structure comprises essentially a plurality of holes of substantially cylindrical shape, the axes of the cylinders being mutually parallel and perpendicular to the mid-plane of the stripe of the active zone.

Advantageously, the stripe has a length of about one millimetre and the structure has a width of a few tens of microns in the direction of the stripe, the holes have a mean diameter of around one hundred nanometres and a mean depth of three microns and the distance separating a hole from its immediate neighbour is a few hundred nanometres.

Advantageously, the density of holes in each structure is substantially uniform.

Advantageously, the density of holes in each structure varies continuously in a direction parallel to that of the stripe or in a direction perpendicular to that of the stripe.

The invention also relates to a process for producing a semiconductor optical amplifier according to the invention, characterized in that it comprises at least the following production steps:
- 1 st step: production of the active zone under the upper face of a substrate - there are a number of techniques known to those skilled in the art which allow this step to be carried out;
- 2nd step: deposition of a protective layer on said upper face of said substrate away from unprotected zones corresponding to the implantation of the future holes constituting the photonic-crystal waveguide, the deposition being carried out by resist deposition, masking and exposure by electron beams;
- 3rd step: etching of the holes in the unprotected zones; and
- 4th step: implantation of the control electrodes.

The invention will be more clearly understood and other advantages will become apparent on reading the following description given by way of non-limiting example and thanks to the appended figures in which:
- Figure 1 shows the variation of the gain curve as a function of the wavelength in a semiconductor optical amplifier according to the prior art;
- Figure 2 shows a view from above of an optical amplifier according to the invention;
- Figure 3 shows the variation of the gain curve as a function of the wavelength in a semiconductor optical amplifier according to the invention;
- Figures 4 to 6 show various configurations of the photonic-crystal waveguide structure according to the invention; and
- Figures 7 to 11 show, seen in cross section, the various steps of the process for producing an optical amplifier according to the invention, the cross sections on the left of the figures being away from the photonic-crystal zone, while the cross sections on the right of the figures are carried out at the centre of the photonic-crystal zone.

Conventionally, a photonic amplifier comprises an active zone produced in a substrate. Said zone generally has the shape of a straight stripe. It is produced in a material having a high index relative to that of the substrate so as to ensure guided propagation of the optical waves. Its length is of the order of one millimetre, its width is a few microns and its thickness is a few hundred nanometres. Electrodes provide the injection of pump current into the active zone so as to ensure the population inversion needed to amplify an optical signal passing through the active zone. As indicated in Figure 1, the amplification gain depends on the wavelength. It passes through a maximum and, as mentioned, has a spectral width called OBW.

In an amplifier according to the invention as shown in the top view of Figure 2, the amplifier 1 includes, in the vicinity of the active zone 2, an electrically tuneable photonic-crystal waveguide 3. To make it easier to examine the figures representing the amplifier or the waveguide, all the figures are drawn in the same reference frame (O,X,Y,Z). Thus, the top view shown in Figure 2 is in the (O,X,Y) plane. This photonic-crystal waveguide 3 consists of two identical structures 4 symmetrically placed on either side of the stripe of the active zone 2.

Photonic crystals are periodic structures designed to modify the propagation of electromagnetic waves. Since the underlying physical phenomenon is the diffraction of light by the microstructure, the periodicity of the crystal must be of the order of one half of the wavelength of the incident light in order to generate interference patterns, i.e. between 400 and 600 nanometres for operating in the near infrared. These structures are presently being used in many experiments in optics, such as spontaneous emission inhibition, high-reflectivity omnidirectional mirrors, low-loss waveguides, etc. Photonic crystals already allow light to be controlled and manipulated for the purpose of telecommunication-type applications. These crystals have in fact reached the level of maturity needed for developing industrial applications.

For the desired application, the waveguide structures essentially consist of a plurality of regularly deposited micro-holes 5. The waveguide therefore has the property of attenuating the optical signal passing through the active zone. This attenuation, which is dependent on the wavelength, is created by the coupling between the fundamental mode and a counterpropagating higher-order mode. It passes through a maximum for a given wavelength. This maximum may be controlled by injecting a current through the waveguide by means of electrodes. The attenuation also depends on the physical characteristics of the waveguide. Thus, by varying both the current flowing through the waveguide and its physical characteristics, it is possible to attenuate the initial curve of the active zone in its maximum gain region in order to obtain a gain curve having a "plateau" in which the variations, as a function of the wavelength, are small. Thus, the OBW of the amplifying medium is enlarged, which is the desired objective.

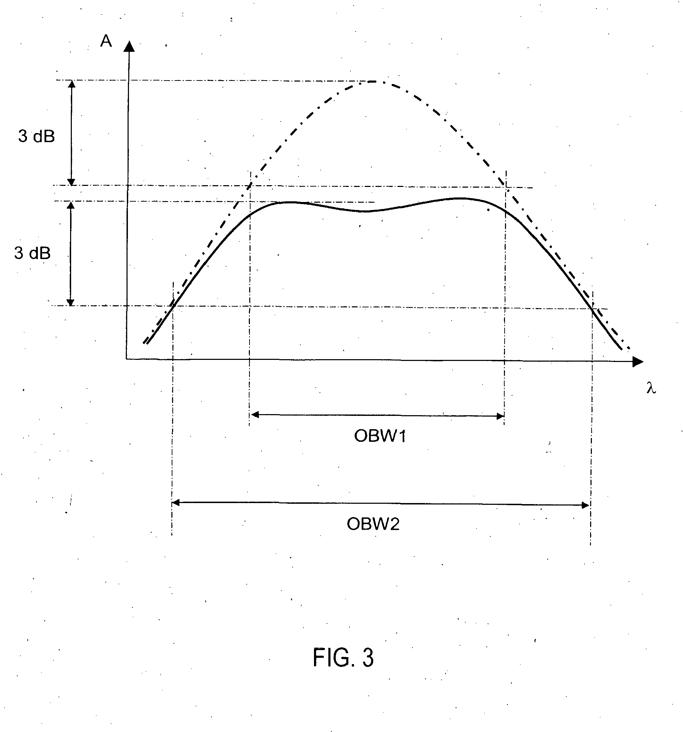

Thus, in Figure 3, the gain curve of the active zone alone represented by the dot-dash line has a first bandwidth OBW1, while the gain curve of the amplifier with a waveguide represented by the continuous line has a second bandwidth OBW2, substantially greater than OBW1. Optimization of the gain curve by introducing a photonic crystal in the vicinity of the active zone may be accomplished by computer simulation. For this purpose, it is possible to use the "Fdtd 2d simulator for photonic devices (F2P)" simulation software developed by Min Qiu of the Royal Institute of Technology of Sweden (or KTH).

The holes 5 have substantially a cylindrical shape, the axes of the cylinders being mutually parallel and perpendicular to the mid-plane of the stripe of the active zone. In the figures, the axes of the holes are parallel to the (O, Z) direction.

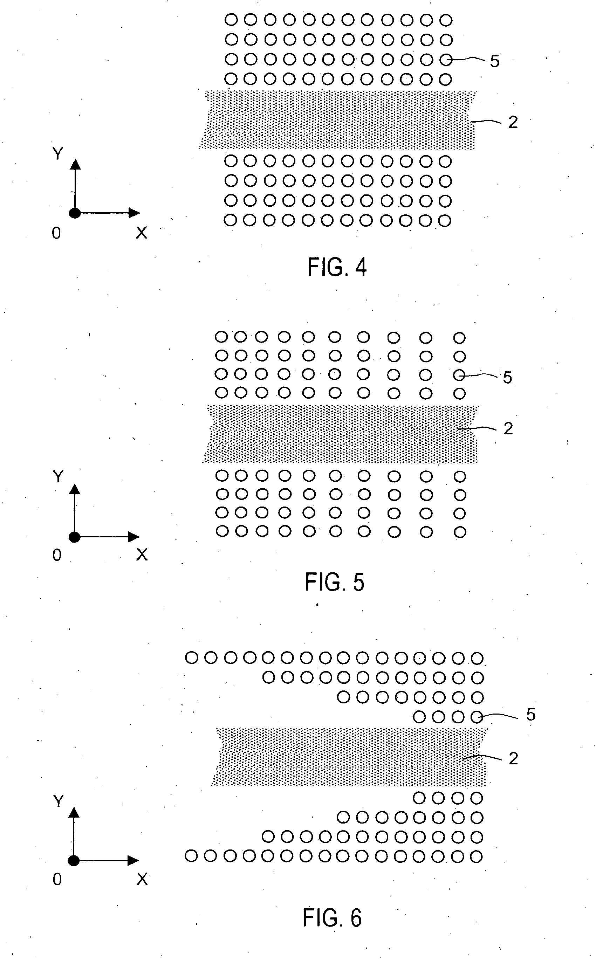

The main characteristics of the waveguide are essentially the geometrical parameters of the holes constituting the waveguide and their distribution. In general, the holes have a diameter of about 100 nanometres and a depth of 3 microns. The distribution of the holes also allows the attenuation introduced by the waveguide to be modulated. As non-limiting examples, Figures 4, 5 and 6 show three possible distributions of holes, again in top view. In Figure 4, the density of holes 5 on either side of the active zone is substantially uniform. In Figure 5, the density of holes 5 in each structure varies continuously in a direction OX parallel to that of the stripe. In Figure 6, the density of holes 5 in each structure varies continuously in a direction OY perpendicular to that of the stripe of the active zone. Of course, other distributions are possible.

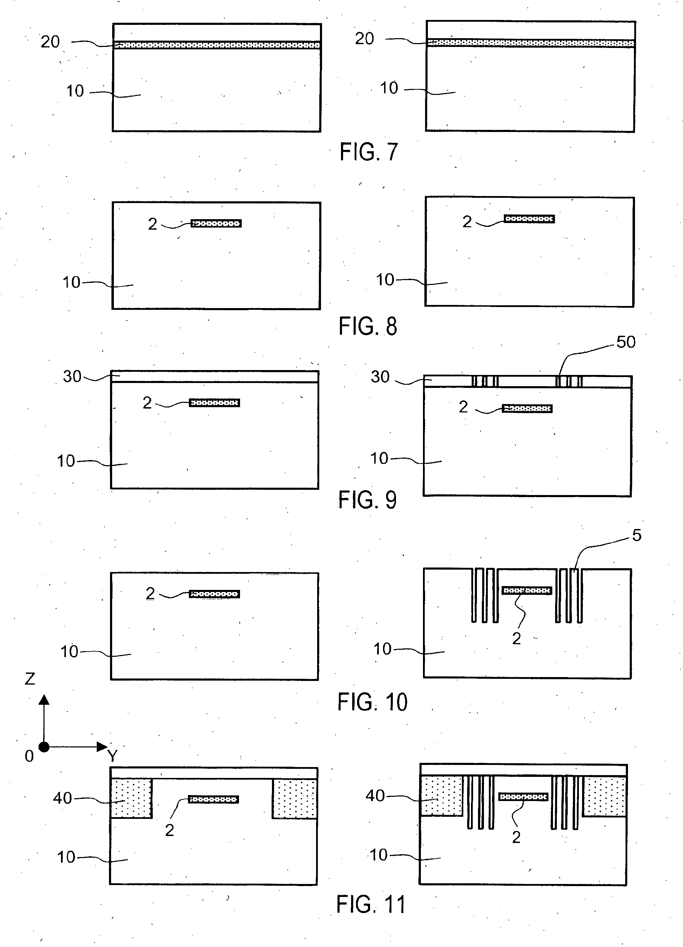

The technical production of a semiconductor optical amplifier poses no particular problems. As an example, Figures 7 to 11 show, seen in cross section in the (O,Y,Z) plane, the various steps of the process for producing an optical amplifier according to the invention, the cross sections on the left-hand side being carried out away from the photonic-crystal zone, and the cross sections on the right-hand side being carried out in the centre of the photonic-crystal zone.

In these figures, the four main production steps are shown:
Step 1 shown in Figures 7 and 8: production of the active zone 2:
   - production of the layer 20 constituting the active structure on a substrate 10, this layer being common to the photonic-crystal zone;
   - production of the mesa constituting the active zone 2 by etching the layer constituting the active structure followed by filling-in of the mesa; and
   - production of an upper layer on top of the buried active zone;
Step 2 shown in Figure 9: production of the imprint for the photonic waveguide:
   - deposition of a protective resist layer 30 on the upper layer;
   - masking of the zones located away from the waveguide; and
   - exposure of the resist layer, for example by e-beam lithography, making it possible to eliminate the protective resist at the location of the future holes 50 constituting the photonic waveguide;
Step 3 shown in Figure 10: production of the waveguide:
   - Etching of the holes 5 constituting the photonic waveguide; and
   - cleaning of the protective resist; and
Step 4 shown in Figure 11: finishing:
   - metallization of the zones 40 corresponding to the electrodes for controlling the active zone and the waveguide.

## Claims

1. Semiconductor optical amplifier (1) possessing an active zone (2), said active zone having an initial gain curve dependent on the wavelength and possessing a first bandwidth (OBW1), **characterized in that** said amplifier (1) includes, in the vicinity of said active zone, an electrically tuneable photonic-crystal waveguide, said waveguide being dimensioned and tunable so that the final gain curve of the optical amplifier has a second bandwidth (OBW2) greater than the first bandwidth (OBW1).

2. Optical amplifier according to Claim 1, **characterized in that** since the active zone (2) has substantially the form of a thin elongate straight stripe, the photonic-crystal waveguide consists of two identical structures (4) placed symmetrically on either side of said stripe.

3. Optical amplifier according to Claim 2, **characterized in that** each structure (4) comprises essentially a plurality of holes (5) of substantially cylindrical shape, the axes of the cylinders being mutually parallel and perpendicular to the mid-plane of the stripe of the active zone (2).

4. Optical amplifier according to Claim 3, **characterized in that** the stripe of the active zone has a length of about one millimetre and each structure (4) has a width of a few tens of microns in the direction of the stripe, **in that** the holes (5) have a mean diameter of around 100 nanometres and a mean depth of 3 microns and **in that** the distance separating a hole from its immediate neighbour is a few hundred nanometres.

5. Optical amplifier according to Claim 3, **characterized in that** the density of holes (5) in each structure is substantially uniform.

6. Optical amplifier according to Claim 3, **characterized in that** the density of holes (5) in each structure (4) varies continuously in a direction parallel to that of the stripe.

7. Optical amplifier according to Claim 3, **characterized in that** the density of holes (5) in each structure (4) varies continuously in a direction perpendicular to that of the stripe.

8. Process for producing a semiconductor optical amplifier according to one of the preceding claims, **characterized in that** it comprises at least the following production steps:
• 1 st step: production of the active zone (2) on the upper face of a substrate (10);
• 2nd step: deposition of a protective layer (30) on said upper face of said substrate away from unprotected zones corresponding to the implantation of the future holes constituting the photonic-crystal waveguide, the deposition being carried out by resist deposition, masking and exposure by electron beams;
• 3rd step: etching of the holes (5) in the unprotected zones; and
• 4th step: implantation of the control electrodes.

## Patentansprüche

1. Optischer Halbleiterverstärker (1) mit einem aktiven Bereich (2), wobei der besagte aktive Bereich eine von der Wellenlänge abhängende anfängliche Verstärkungskurve aufweist und über eine erste Bandbreite (OBW1) verfügt, **dadurch gekennzeichnet, dass** der besagte Verstärker (1) in der Umgebung des besagten aktiven Bereichs einen elektrisch abstimmbaren photonischen Kristallwellenleiter umfasst, wobei der besagte Wellenleiter derart dimensioniert und abstimmbar ist, dass die endgültige Verstärkungskurve des optischen Verstärkers eine zweite Bandbreite (OBW2) aufweist, die größer als die erste Bandbreite (OBW1) ist.

2. Optischer Verstärker nach Anspruch 1, **dadurch gekennzeichnet, dass** der photonische Kristallwellenleiter angesichts dessen, dass der aktive Bereich (2) im Wesentlichen die Form eines schmalen, länglichen, geraden Streifens aufweist, aus zwei identischen Strukturen (4) besteht, welche symmetrisch an beiden Seiten des besagten Streifens angeordnet sind.

3. Optischer Verstärker nach Anspruch 2, **dadurch gekennzeichnet, dass** jede Struktur (4) hauptsächlich eine Vielzahl von Löchern (5) einer im Wesentlichen zylinderartigen Form umfasst, wobei die Achsen der Zylinder parallel zueinander und senkrecht zur Mittelebene des Streifens des aktiven Bereichs (2) verlaufen.

4. Optischer Verstärker nach Anspruch 3, **dadurch gekennzeichnet, dass** der Streifen des aktiven Bereichs eine Länge von rund einem Millimeter aufweist und jede Struktur (4) eine Breite von einigen zehn Mikrometern in der Richtung des Streifens aufweist, dass die Löcher (5) einen mittleren Durchmesser von rund 100 Nanometern und eine mittlere Tiefe von 3 Mikrometern aufweisen, und dass der Abstand, der ein Loch von seinem unmittelbaren Nachbarn trennt, einige hundert Nanometer beträgt.

5. Optischer Verstärker nach Anspruch 3, **dadurch gekennzeichnet, dass** die Dichte der Löcher (5) in jeder Struktur im Wesentlichen einheitlich ist.

6. Optischer Verstärker nach Anspruch 3, **dadurch gekennzeichnet, dass** die Dichte der Löcher (5) in jeder Struktur (4) in einer parallel zur Richtung des Streifens verlaufenden Richtung kontinuierlich variiert.

7. Optischer Verstärker nach Anspruch 3, **dadurch gekennzeichnet, dass** die Dichte der Löcher (5) in jeder Struktur (4) in einer senkrecht zur Richtung des Streifens verlaufenden Richtung kontinuierlich variiert.

8. Verfahren zur Herstellung eines optischen Halbleiterverstärkers gemäß einem der vorstehenden Ansprüche, **dadurch gekennzeichnet, dass** es zumindest die folgenden Herstellungsschritte umfasst:
• 1. Schritt: Herstellen des aktiven Bereichs (2) auf der oberen Fläche eines Substrats (10);
• 2. Schritt: Auftragen einer Schutzschicht (30) auf der besagten oberen Fläche des besagten Substrats fernab von ungeschützten Bereichen, welche der Anordnung der zukünftigen Löcher, die den photonischen Kristallwellenleiter bilden, entsprechen, wobei das Auftragen durch Aufbringen einer Resistschicht, Maskieren und Elektronenstrahlbelichtung erfolgt;
• 3. Schritt: Ätzen der Löcher (5) in den ungeschützten Bereichen; und
• 4. Schritt: Anordnen der Steuerelektroden.

## Revendications

1. Amplificateur optique à semi-conducteur (1) possédant une zone active (2), ladite zone active présentant une courbe de gain initiale qui dépend de la longueur d'onde et possédant une première bande passante (OBW1), **caractérisé en ce que** ledit amplificateur (1) comprend, à proximité de ladite zone active, un guide d'onde à cristaux photoniques électriquement accordable, ledit guide d'onde étant dimensionné et accordable de sorte que la courbe de gain finale de l'amplificateur optique présente une deuxième bande passante (OBW2) supérieure à la première bande passante (OBW1).

2. Amplificateur optique selon la revendication 1, **caractérisé en ce que**, étant donné que la zone active (2) a sensiblement la forme d'une bande droite allongée et fine, le guide d'onde à cristaux photoniques est constitué de deux structures identiques (4) placées symétriquement de chaque côté de ladite bande.

3. Amplificateur optique selon la revendication 2, **caractérisé en ce que** chaque structure (4) comprend généralement une pluralité d'orifices (5) de forme sensiblement cylindrique, les axes des cylindres étant mutuellement parallèles et perpendiculaires au plan médian de la bande de la zone active (2).

4. Amplificateur optique selon la revendication 3, **caractérisé en ce que** la bande de la zone active a une longueur d'environ un millimètre et chaque structure (4) a une largeur de quelques dizaines de microns dans la direction de la bande, **en ce que** les orifices (5) ont un diamètre moyen d'environ 100 nanomètres et une profondeur moyenne de 3 microns et **en ce que** la distance séparant un orifice de son voisin immédiat est de quelques centaines de nanomètres.

5. Amplificateur optique selon la revendication 3, **caractérisé en ce que** la densité des orifices (5) dans chaque structure est sensiblement uniforme.

6. Amplificateur optique selon la revendication 3, **caractérisé en ce que** la densité des orifices (5) dans chaque structure (4) varie continuellement dans une direction parallèle à celle de la bande.

7. Amplificateur optique selon la revendication 3, **caractérisé en ce que** la densité des orifices (5) dans chaque structure (4) varie continuellement dans une direction perpendiculaire à celle de la bande.

8. Processus de production d'un amplificateur optique à semi-conducteur selon l'une des revendications précédentes, **caractérisé en ce qu'**il comprend au moins les étapes de production suivantes :
• 1^{ère} étape : production de la zone active (2) sur la face supérieure d'un substrat (10) ;
• 2^{ème} étape : dépôt d'une couche protectrice (30) sur ladite face supérieure dudit substrat à distance des zones non-protégées correspondant à l'implantation des futurs orifices constituant le guide d'onde à cristaux photoniques, le dépôt étant réalisé par dépôt de résistance, par masquage et par exposition par des faisceaux d'électrons ;
• 3^{ème} étape : gravure des orifices (5) dans les zones non-protégées ; et
• 4^{ème} étape : implantation des électrodes de commande.
